# EUROPEAN PATENT APPLICATION

(11) **EP 4 715 791 A1**
(43) Date of publication of application: **25.03.2026**
(21) Application number: 24902122.1
(22) Date of filing: 31.07.2024
(51) Int. Cl.: G09F 9/30

(54) **FLEXIBLE SCREEN AND FOLDING ELECTRONIC DEVICE**

(30) Priority: 12.12.2023 CN 202311709312
(71) Applicant: REALME MOBILE TELECOMMUNICATIONS (SHENZHEN) CO., LTD., Shenzhen, Guangdong 518066 (CN)
(72) Inventor: ZHAN, Xuechao, Shenzhen, Guangdong 518066 (CN)
(74) Representative: Novagraaf Technologies
(86) International application number: PCT/CN2024/108873
(87) International publication number: WO 2025/123696

(57) **Abstract**

A flexible screen (10) and a folding electronic device (100). The flexible screen (10) comprises a flexible display panel (11), equal-thickness ultrathin glass (12), a screen protection layer (13), and a support stack layer (14), wherein the equal-thickness ultrathin glass (12) is connected to a light output side of the flexible display panel (11); the screen protection layer (13) is connected to the side of the equal-thickness ultrathin glass (12) facing away from the flexible display panel (11); an overhead area is formed between the screen protection layer (13) and the flexible display panel (11); and the support stack layer (14) is arranged in the overhead area, the support stack layer (14) is connected between the flexible display panel (11) and the screen protection layer (13), the support stack layer (14) protrudes from an edge of the flexible display panel (11), and the support stack layer (14) and the equal-thickness ultrathin glass (12) are spaced apart to form a gap (J).

## Description

The present application claims priority to Chinese Patent Application No. 2023117093125, entitled "FLEXIBLE SCREEN AND FOLDABLE ELECTRONIC DEVICE", filed on December 12, 2023, which is herein incorporated by reference in its entirety.

### TECHNICAL FIELD

The present disclosure relates to the technical field of electronic devices, and in particular to a flexible screen and a foldable electronic device.

### BACKGROUND

A foldable electronic device adopts a flexible screen to achieve foldable use, improving portability and gaining favor from consumers. However, a decorative member between a middle frame and an edge of the flexible screen may occupy a certain design size, which visually results in a relatively wide bezel area and is not conducive to enhancing the appearance. If the decorative member is abruptly removed, there will be a lack of cushioning provided by the decorative member between the middle frame and the flexible screen. Accordingly, in a case where the foldable electronic device falls to the ground or hits a hard object, the flexible screen is prone to breakage. Therefore, this structure cannot have good impact resistance performance. Moreover, due to the need for cost control, it becomes increasingly difficult to reduce costs while improving the impact resistance of the flexible screen.

### SUMMARY OF THE DISCLOSURE

The present disclosure provides a flexible screen and a foldable electronic device.

A flexible screen includes a flexible display panel, equal thickness ultra-thin glass, a screen protection layer, and a support stacking layer. The flexible display panel includes a light-emitting surface. The equal thickness ultra-thin glass is connected to the light-emitting surface of the flexible display panel, wherein an edge of the equal thickness ultra-thin glass is disposed on an inner side of an edge of the flexible display panel. The screen protection layer is connected to a surface of the equal thickness ultra-thin glass away from the flexible display panel, wherein an edge of the screen protection layer is disposed on an outer side of the edge of the flexible display panel, an overhead area is defined between the screen protection layer and the flexible display panel, and the overhead area is disposed on an outer side of the edge of the equal thickness ultra-thin glass. The support stacking layer is disposed in the overhead area, wherein the support stacking layer is connected between the flexible display panel and the screen protection layer, the support stacking layer protrudes from the flexible display panel, and the support stacking layer is spaced apart from the equal thickness ultra-thin glass to define a gap.

A foldable electronic device includes the above flexible screen.

### BRIEF DESCRIPTION OF THE DRAWINGS

In order to more clearly illustrate the technical solutions in some embodiments of the present disclosure or in the related art, hereinafter, the accompanying drawings that are used in the description of some embodiments or the related art will be briefly described. Obviously, the accompanying drawings in the description below are merely the accompanying drawings in some embodiments of the present disclosure. For those of ordinary skill in the art, other accompanying drawings may be obtained based on these accompanying drawings without any creative efforts.
FIG. 1 is a schematic view of a foldable electronic device in a fully unfolded state provided by some embodiments of the present disclosure.
FIG. 2 is a schematic view of the foldable electronic device in another state provided by some embodiments of the present disclosure.
FIG. 3 is a top view of the foldable electronic device provided by some embodiments of the present disclosure, where a dashed structure indicates an installation position of a hinge mechanism.
FIG. 4 is a cross-sectional structural schematic view of the foldable electronic device along a D-D line of FIG. 3 provided by some embodiments of the present disclosure.
FIG. 5 is another cross-sectional structural schematic view of the foldable electronic device along the D-D line of FIG. 3 provided by some embodiments of the present disclosure.
FIG. 6 is a cross-sectional structural schematic view of a flexible screen of the foldable electronic device provided by some embodiments of the present disclosure.
FIG. 7 is another cross-sectional structural schematic view of the flexible screen of the foldable electronic device provided by some embodiments of the present disclosure.

Explanation of reference signs: 100. foldable electronic device; 100a. first connection member; 100b. second connection member; 100c. third connection member; 10. flexible screen; WQ. screen external expansion area; VA. display area; BM. black border area; 11. flexible display panel; 12. equal thickness ultra-thin glass; 13. screen protection layer; 14. support stacking layer; 14a. substrate layer; 14b. pressure-sensitive adhesive layer; J. gap; 15. filling member; 16. ink layer; OCA1. first optical adhesive layer; OCA2. second optical adhesive layer; 17. back film layer; 18. panel bottom protective layer; 19. support member; 20. middle frame; 22. first frame body; 24. second frame body; P. flat part; T. step part; 30. hinge mechanism.

### DETAILED DESCRIPTION

In order to facilitate the understanding of the embodiments of the present disclosure, a more comprehensive description of the embodiments of the present disclosure will be provided below with reference to accompanying drawings. The preferred embodiment of the present disclosure is shown in the accompanying drawings. However, the embodiments of the present disclosure may be implemented in many different forms, and are not limited to the embodiments described herein. On the contrary, the purpose of providing these embodiments is to make the disclosure of the embodiments of the present disclosure more thorough and comprehensive.

As used herein, "foldable electronic device" refers to a device that is capable of receiving and/or transmitting a communication signal and is connected by any one or more of the following connection methods: (1) wired line connection methods, such as public switched telephone networks (PSTN), digital subscriber lines (DSL), digital cables, or direct cable connections; (2) wireless interface methods, such as cellular networks, wireless local area networks (WLAN), digital television networks like DVB-H networks, satellite networks, and AM-FM broadcast transmitters.

As a type of electronic device, the foldable electronic device that is configured to communicate through a wireless interface may be referred to as "a mobile terminal". In some embodiments, the mobile terminal includes but is not limited to the following electronic device: (1) a satellite phone or a cellular phone; (2) a personal communications system (PCS) terminal that is able to combine a cellular radiotelephone with data processing, fax, and data communication capabilities; (3) a radiotelephone, a pager, an internet/intranet access device, a web browser, a notepad, a calendar, a personal digital assistant (PDA) equipped with a global positioning system (GPS) receiver; (4) a conventional laptop and/or handheld receiver; (5) a conventional laptop and/or handheld radiotelephone transceiver, etc.

An embodiment of the present disclosure provides a flexible screen, including a flexible display panel, equal thickness ultra-thin glass, a screen protection layer, and a support stacking layer. The flexible display panel includes a light-emitting surface. The equal thickness ultra-thin glass is connected to the light-emitting surface of the flexible display panel, wherein an edge of the equal thickness ultra-thin glass is disposed on an inner side of an edge of the flexible display panel. The screen protection layer is connected to a surface of the equal thickness ultra-thin glass away from the flexible display panel, wherein an edge of the screen protection layer is disposed on an outer side of the edge of the flexible display panel, an overhead area is defined between the screen protection layer and the flexible display panel, and the overhead area is disposed on an outer side of the edge of the equal thickness ultra-thin glass. The support stacking layer is disposed in the overhead area, wherein the support stacking layer is connected between the flexible display panel and the screen protection layer, the support stacking layer protrudes from the flexible display panel, and the support stacking layer is spaced apart from the equal thickness ultra-thin glass to define a gap.

In some embodiments, the flexible screen further includes a filling member, wherein the filling member is disposed in the gap, and a material hardness of the filling member is less than that of the equal thickness ultra-thin glass.

In some embodiments, the filling member is formed by curing an optical adhesive filled in the gap.

In some embodiments, the flexible screen further includes an ink layer, wherein the ink layer is disposed between the screen protection layer and the support stacking layer, and the ink layer completely covers the gap.

In some embodiments, an overlap width between the ink layer and the equal thickness ultra-thin glass is defined as k1, and 0.1mm ≤ k1 ≤ 0.5mm.

In some embodiments, k1 is 0.1mm, 0.2mm, 0.3mm, 0.4mm, or 0.5mm.

In some embodiments, a width of the gap is defined as k2, and 0.1mm ≤ k2 ≤ 0.5mm.

In some embodiments, k2 is 0.1mm, 0.2mm, 0.3mm, 0.4mm, or 0.5mm.

In some embodiments, an overlap width between the support stacking layer and the flexible display panel is defined as k3, and 0.2mm ≤ k3 ≤ 1mm.

In some embodiments, k3 is 0.2mm, 0.3mm, 0.4mm, 0.5mm, 0.7mm, or 1mm.

In some embodiments, the support stacking layer includes a substrate layer and a pressure-sensitive adhesive layer, and the substrate layer is connected to the flexible display panel through the pressure-sensitive adhesive layer.

In some embodiments, a material of the substrate layer includes polyethylene terephthalate, transparent polyimide, or glass.

In some embodiments, a thickness of the substrate layer is greater than that of the pressure-sensitive adhesive layer.

In some embodiments, the flexible screen further includes a first optical adhesive layer, wherein the first optical adhesive layer covers the equal thickness ultra-thin glass and the support stacking layer, and the first optical adhesive layer connects the screen protection layer to the equal thickness ultra-thin glass and the support stacking layer.

In some embodiments, the flexible screen further includes a second optical adhesive layer, wherein the equal thickness ultra-thin glass is connected to the flexible display panel through the second optical adhesive layer, and a thickness of the equal thickness ultra-thin glass is less than that of the second optical adhesive layer.

In some embodiments, the support stacking layer includes a substrate layer and a pressure-sensitive adhesive layer, the substrate layer is connected to the flexible display panel through the pressure-sensitive adhesive layer, and a thickness of the substrate layer is greater than that of the pressure-sensitive adhesive layer.

In some embodiments, the flexible screen further includes a back film layer, a panel bottom protective layer, and a support member, wherein the back film layer, the panel bottom protective layer, and the support member are sequentially disposed on a back surface of the flexible display panel.

Another embodiment of the present disclosure provides a foldable electronic device including the flexible screen of any one of the above embodiments.

In some embodiments, the foldable electronic device further includes a middle frame and a hinge mechanism, wherein the middle frame includes a first frame body and a second frame body, and the hinge mechanism is connected between the first frame body and the second frame body; the flexible screen is connected to the first frame body and the second frame body, and the flexible screen covers the hinge mechanism; and each of the first frame body and the second frame body includes a flat part and a step part protruding from the flat part, a surface of the flexible display panel of the flexible screen away from the light-emitting surface is connected to the flat part, and a part of the support stacking layer protruding from the flexible display panel is connected to the step part.

In some embodiments, an outer edge of the support stacking layer is spaced apart from a side wall of the step part.

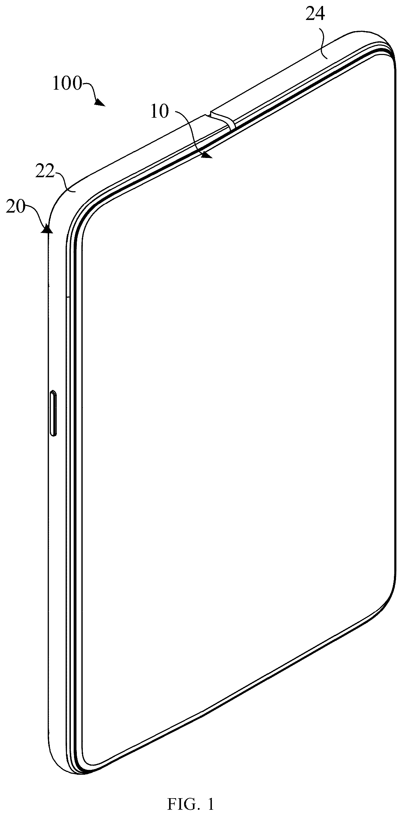

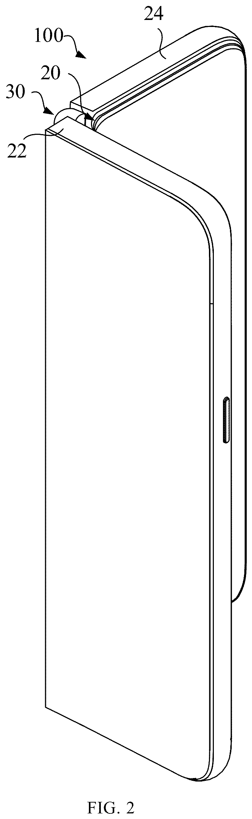

As illustrated in FIGS. 1 and 2, some embodiments of the present disclosure provide a foldable electronic device 100 including a flexible screen 10. By utilizing foldable performance of the flexible screen 10, the foldable electronic device 100 may switch between a folded state and a fully unfolded state for use.

The foldable electronic device 100 further includes a middle frame 20 and a hinge mechanism 30. The middle frame 20 includes a first frame body 22 and a second frame body 24. The hinge mechanism 30 is connected between the first frame body 22 and the second frame body 24, so that the first frame body 22 and the second frame body 24 are able to rotate relative to each other.

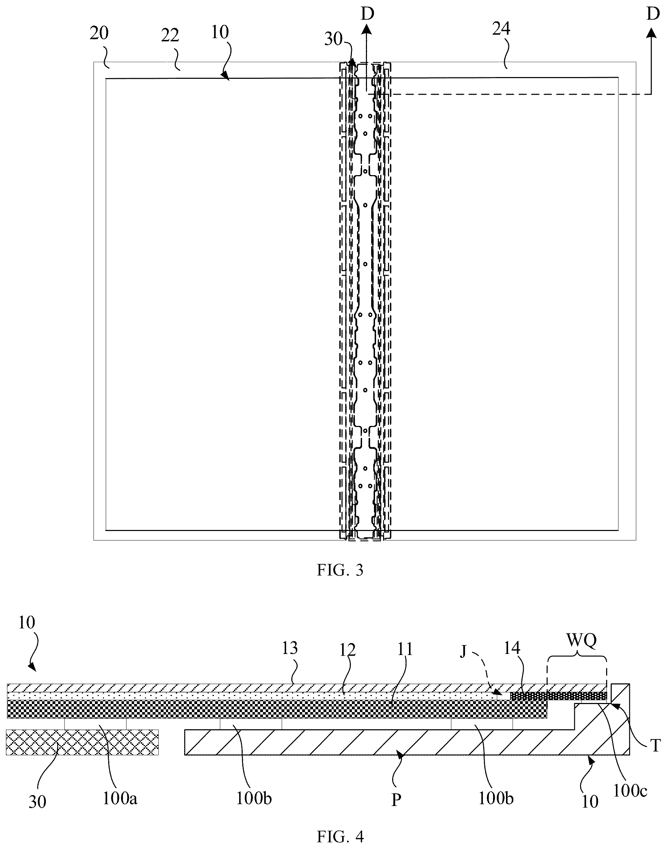

As illustrated in FIG. 3, the flexible screen 10 is connected to the first frame body 22 and the second frame body 24. The flexible screen 10 covers the hinge mechanism 30. The first frame body 22 may be connected to the flexible screen 10 through a first structural member, and the second frame body 24 may be connected to the flexible screen 10 through a second structural member. The first structural member and the second structural member may be adhesive layers or screws, which are not limited here.

The middle frame 20 defines an accommodation chamber (not illustrated in figures), and the foldable electronic device 100 may further include a circuit board (not illustrated in the figures) and a battery (not illustrated in the figures), the circuit board and the battery may be disposed in the accommodation chamber of the middle frame 20. The circuit board may be integrated with a processor, a power management module, a storage unit, and a baseband chip of the foldable electronic device 100. The flexible screen 10 is connected to the processor for communication, and the battery is configured to provide power to electronic components on the flexible screen 10 and the circuit board. In some embodiments, the foldable electronic device 100 may further include a camera module (not illustrated in the figures), the camera module is connected to the circuit board for communication, and the battery is configured to provide power to the camera module.

As illustrated in FIGS. 3 and 4, each of the first frame body 22 and the second frame body 24 includes a flat part P and a step part T protruding from the flat part P. The flexible screen 10 is connected to the flat part P, and a part of the flexible screen 10 that is close to an edge of the flexible screen 10 is connected to the step part T. The part where the flexible screen 10 is connected to the step part T may be referred to as a screen external expansion area WQ.

The present inventor found that in a case where the foldable electronic device 100 drops or hits a hard object, the part where the flexible screen 10 is connected to the step part T is most prone to breakage. That is, impact resistance of the screen external expansion area WQ is a bottleneck of drop resistance performance of the foldable electronic device 100. The present inventor attempted to use ultra flexible glass (UFG) as a cover plate for the flexible screen 10. Due to UFG being thinner at a bending position and thicker at a connection position where the UFG is connected to the middle frame, the bending position has good bending performance while also ensuring impact resistance at the connection position where the UFG is connected to the middle frame. With further research, the present inventor found that in a case where UFG is used as the cover plate, it is necessary to perform slotting processing on the bending position to improve the bending performance by thinning the glass material here, and inorganic materials need to be used to fill a slot. This processing technology is complex and may increase costs. In order to reduce costs, the present inventor further explored solutions that balance impact resistance and cost reduction.

In some embodiments, as illustrated in FIGS. 2 and 3, the flexible screen 10 includes a flexible display panel 11, equal thickness ultra-thin glass 12, a screen protection layer 13, and a support stacking layer 14. The flexible display panel 11 includes a light-emitting surface, and the light-emitting surface is a surface where the flexible display panel 11 emits light for display.

The equal thickness ultra-thin glass 12 is connected to the light-emitting surface of the flexible display panel 11. An edge of the equal thickness ultra-thin glass 12 is disposed on an inner side of an edge of the flexible display panel 11, which means that the edge of the equal thickness ultra-thin glass 12 does not extend beyond the edge of the flexible display panel 11. It should be noted that the screen external expansion area WQ is defined relative to the flexible display panel 11. In some embodiments, a part protruding from the edge of the flexible display panel 11 is the screen external expansion area WQ. In some embodiments, the edge of the equal thickness ultra-thin glass 12 does not extend beyond the edge of the flexible display panel 11, so that the equal thickness ultra-thin glass 12 does not extend to the screen external expansion area WQ.

The screen protection layer 13 is connected to a side of the equal thickness ultra-thin glass 12 away from the flexible display panel 11. An edge of the screen protection layer 13 is disposed on an outer side of the edge of the flexible display panel 11, and a part of the screen protection layer 13 extending from the edge of the flexible display panel 11 is disposed in the screen external expansion area WQ. An overhead area is defined between the screen protection layer 13 and the flexible display panel 11, and the overhead area is disposed on an outer side of the edge of the equal thickness ultra-thin glass 12. The support stacking layer 14 is disposed in the overhead area, and the support stacking layer 14 is connected between the flexible display panel 11 and the screen protection layer 13. The support stacking layer 14 protrudes from the edge of the flexible display panel 11, and the support stacking layer 14 is spaced apart from the equal thickness ultra-thin glass 12 to define a gap J.

In the flexible screen 10 of some embodiments of the present disclosure, the screen protection layer 13 is connected to the side of the equal thickness ultra-thin glass 12 away from the flexible display panel 11, and the overhead area that is disposed on the outer side of the edge of the equal thickness ultra-thin glass 12 is defined between the screen protection layer 13 and the flexible display panel 11. The support stacking layer 14 is disposed in the overhead area, and the support stacking layer 14 protrudes from the edge of the flexible display panel 11. Therefore, the support stacking layer 14 may be configured to stably support the screen protection layer 13, and the protruding support stacking layer 14 may meet connection requirements with bezels of the foldable electronic device 100. Due to the support stacking layer 14 spaced apart from the equal thickness ultra-thin glass 12, the support stacking layer 14 may alleviate an impact force in a case where the foldable electronic device 100 experiences an external impact, thereby reducing the impact force on the equal thickness ultra-thin glass 12 and lowering the risk of breakage of the equal thickness ultra-thin glass 12. Therefore, impact resistance is improved. With this structural arrangement, a thickness of each part of the equal thickness ultra-thin glass 12 is consistent, eliminating the need for defining the slot and filling the slot of the equal thickness ultra-thin glass 12. As a result, the process is simplified and costs are reduced. Therefore, this structure of the foldable electronic device 100 in the present disclosure may simultaneously improve impact resistance and reduce costs.

As illustrated in FIG. 4, a surface of the flexible display panel 11 of the flexible screen 10 away from the light-emitting surface is connected to the flat part P, and the part of the support stacking layer 14 protruding from the flexible display panel 11 is connected to the step part T. In some embodiments, the part of the support stacking layer 14 protruding from the flexible display panel 11 refers to the part of the support stacking layer 14 corresponding to the screen external expansion area WQ. The support stacking layer 14 is disposed on a surface of the screen protection layer 13 facing the flexible display panel 11, so that the support stacking layer 14 may support the screen protection layer 13. Moreover, the part of the support stacking layer 14 corresponding to the screen external expansion area WQ is connected to the step part T, which may improve stability of a connection between the flexible screen 10 and the middle frame 20.

In some embodiments, an outer edge of the support stacking layer 14 is spaced apart from a side wall of the step part T, so that there is a gap between the outer edge of the support stacking layer 14 and the side wall of the step part T. Therefore, in a case where the foldable electronic device 100 experiences an impact, a force exerted by the middle frame 20 is isolated by the gap and is not easily transmitted to the support stacking layer 14, thereby reducing the impact force experienced by the flexible screen 10 and improving the drop resistance performance.

The flexible screen 10 may be connected to the hinge mechanism 30 through a first connection member 100a, the flexible screen 10 may be connected to the flat part P through a second connection member 100b, and the flexible screen 10 may be connected to the step part T through a third connection member 100c. In some embodiments, each of the first connection member 100a, the second connection member 100b, and the third connection member 100c may be a double-sided adhesive or formed by curing a hot melt adhesive. Types and quantities of these connection members are not limited here. In some embodiments, the flexible screen 10 is connected to the flat part P through two second connection members 100b.

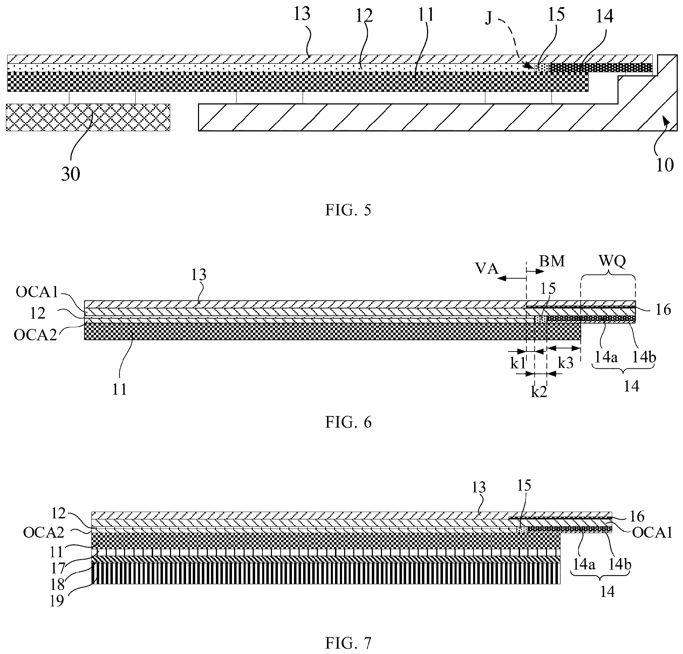

As illustrated in FIG. 5, in some embodiments, the flexible screen 10 further includes a filling member 15, and the filling member 15 is disposed in the gap J. In some embodiments, a material hardness of the filling member 15 is less than that of the equal thickness ultra-thin glass 12. Therefore, the filling member 15 may be configured to provide a buffering effect, so as to reduce the impact force transmitted from the support stacking layer 14 to the equal thickness ultra-thin glass 12, making it less likely for the equal thickness ultra-thin glass 12 to break. Moreover, the filling member 15 fills the gap J, thereby supporting a part of the screen protection layer 13 corresponding to the gap J. Therefore, disposing the filling member 15 may reduce the risk of the breakage of the equal thickness ultra-thin glass 12, while also ensuring the support effect on the screen protection layer 13.

The filling member 15 is formed by curing an optical adhesive filled in the gap J. In this way, during the processing, it is only necessary to fill the gap J with an uncured optical adhesive, and after the optical adhesive is cured, the filling member 15 filled in the gap J may be obtained.

As illustrated in FIG. 6, in some embodiments, the flexible screen 10 further includes an ink layer 16, and the ink layer 16 is disposed between the screen protection layer 13 and the support stacking layer 14. The ink layer 16 is configured to prevent light leakage in a case where the flexible display panel 11 emits light for display. In some embodiments, a position covered by the ink layer 16 corresponds to a black border area BM of the flexible screen 10. In some embodiments, the black border area BM refers to an area surrounding outer sides of a display area VA of the flexible screen 10. An edge of the ink layer 16 close to a center of the flexible screen 10 serves as a dividing line between the black border area BM and the display area VA. In a case where the flexible screen 10 displays, the display area VA emits light to display an image, while the black border area BM does not display the image because it is obscured by the ink layer 16.

In some embodiments, the ink layer 16 completely covers the gap J, so that a user cannot observe the gap J through the screen protection layer 13, and the user also cannot observe the filling member 15 filled in the gap J. This maintains the overall aesthetic appearance of the flexible screen 10.

As illustrated in FIG. 6, an overlap width between the ink layer 16 and the equal thickness ultra-thin glass 12 is defined as k1, and 0.1mm ≤ k1 ≤ 0.5mm. In some embodiments, k1 is 0.1mm, 0.2mm, 0.3mm, 0.4mm, or 0.5mm. The overlap width between the ink layer 16 and the equal thickness ultra-thin glass 12 refers to a distance between the edge of the ink layer 16 close to a middle of the flexible screen 10 and the edge of the equal thickness ultra-thin glass 12. In some embodiments, the overlap width between the ink layer 16 and the equal thickness ultra-thin glass 12 is set to be within a range of "0.1mm ≤ k1 ≤ 0.5mm". On the one hand, it may ensure that the ink layer 16 completely covers the gap J, so that the gap J is defined in the black border area BM of the flexible screen 10, thereby avoiding a situation where the gap J is defined in the display area VA of the flexible screen 10, which could affect the display performance. On the other hand, since an area where the ink layer 16 overlaps with the equal thickness ultra-thin glass 12 is disposed in the black border area BM, the smaller the overlap width is, the more it helps to reduce a width of the black border area BM. Therefore, setting the overlap area within the range of "0.1mm ≤ k1 ≤ 0.5mm" may minimize the width of the black border area BM and improve visual appearance of the foldable electronic device 100.

As illustrated in FIG. 6, a width of the gap J is defined as k2, and 0.1mm ≤ k2 ≤ 0.5mm. In some embodiments, k2 is 0.1mm, 0.2mm, 0.3mm, 0.4mm, or 0.5mm. Since the gap J is disposed in the black border area BM that is formed by the ink layer 16 covering the light-emitting surface of the flexible display panel 11, the smaller the width of the gap J is, the more it helps to reduce the width of the black border area BM. In some embodiments, the width of the gap J is set to be within the range of "0.1mm ≤ k2 ≤ 0.5mm", which is beneficial for reducing the width of the black border area BM. At the same time, the width of the gap J is greater than or equal to 0.1mm, which allows sufficient gap to be reserved between the support stacking layer 14 and the equal thickness ultra-thin glass 12 for easy processing. This ensures that the support stacking layer 14 and the equal thickness ultra-thin glass 12 are not in contact with each other, so that the gap J between the support stacking layer 14 and the equal thickness ultra-thin glass 12 may prevent the support stacking layer 14 from transmitting the impact force to the equal thickness ultra-thin glass 12, reducing the risk of breakage of the equal thickness ultra-thin glass 12 and improving the impact resistance of the flexible screen 10.

An overlap width between the support stacking layer 14 and the flexible display panel 11 is defined as k3, and 0.2mm ≤ k3 ≤ 1mm. In some embodiments, k3 is 0.2mm, 0.3mm, 0.4mm, 0.5mm, 0.7mm, or 1mm. The overlap width between the support stacking layer 14 and the flexible display panel 11 refers to a distance between an inner side edge of the support stacking layer 14 and the edge of the flexible display panel 11. The larger the overlap width between the support stacking layer 14 and the flexible display panel 11, the greater the overlap between the support stacking layer 14 and the flexible display panel 11. Therefore, setting the overlap width between the support stacking layer 14 and the flexible display panel 11 to be within a range of "0.2mm ≤ k3 ≤ 1mm" may ensure sufficient overlap between the support stacking layer 14 and the flexible display panel 11, which is conducive to improving stability of a connection between the support stacking layer 14 and the flexible display panel 11. At the same time, with this structural arrangement, the overlap width between the support stacking layer 14 and the flexible display panel 11 is set to be less than or equal to 1mm. Therefore, the ink layer 16, covering the surface of the support stacking layer 14 away from the flexible display panel 11, has a smaller width at an area where the support stacking layer 14 overlaps with the flexible display panel 11, which is conducive to reducing the width of the black border area BM.

As illustrated in FIG. 6, the support stacking layer 14 includes a substrate layer 14a and a pressure-sensitive adhesive layer 14b. The substrate layer 14a is connected to the flexible display panel 11 through the pressure-sensitive adhesive layer 14b. A material of the substrate layer 14a includes but is not limited to a polyethylene terephthalate (PET) material, a transparent polyimide (PI) material, or a glass material.

The flexible screen 10 further includes a first optical adhesive layer OCA1. The first optical adhesive layer OCA1 covers the equal thickness ultra-thin glass 12 and the support stacking layer 14, and connects the screen protection layer 13 to the equal thickness ultra-thin glass 12 and the support stacking layer 14. In some embodiments, the first optical adhesive layer OCA1 is configured to achieve a connection between the equal thickness ultra-thin glass 12 and the screen protection layer 13, as well as a connection between the support stacking layer 14 and the screen protection layer 13.

The flexible screen 10 further includes a second optical adhesive layer OCA2, and the equal thickness ultra-thin glass 12 is connected to the flexible display panel 11 through the second optical adhesive layer OCA2. A thickness of the equal thickness ultra-thin glass 12 is less than that of the second optical adhesive layer OCA2. In this way, in a case where an overall thickness of the equal thickness ultra-thin glass 12 and the second optical adhesive layer OCA2 does not change, the thinner the equal thickness ultra-thin glass 12 is, the more it helps to improve the bending performance of the flexible screen 10, making the flexible screen 10 easier to bend.

As illustrated in FIG. 6, in the embodiment where the support stacking layer 14 includes the substrate layer 14a and the pressure-sensitive adhesive layer 14b, a thickness of the substrate layer 14a is greater than that of the pressure-sensitive adhesive layer 14b. Therefore, in a case where an overall thickness of the support stacking layer 14 is constant, the thicker the substrate layer 14a is, the stronger a supporting force it provides. Therefore, in a case where the support stacking layer 14 for reinforcement is connected to the middle frame 20, the flexible screen 10 is stably connected to the middle frame 20.

In some embodiments, the flexible screen 10 may further include other structures. In some embodiments, as illustrated in FIG. 7, a back film layer 17, a panel bottom protective layer 18, and a support member 19 are further disposed on a back surface of the flexible display panel 11 (i.e., the surface of the flexible display panel 11 away from a display surface). The structure of the flexible screen 10 may not be repeated here.

The technical features of the above embodiments may be arbitrarily combined. In order to simplify the description, all possible combinations of the technical features in the above embodiments are not described. However, as long as the combinations of the technical features do not contradict, the combinations of the technical features should be considered to be within the scope of the description.

The above embodiments only express several implementation modes of the embodiments of the present disclosure, and the descriptions thereof are more specific and detailed, but cannot be understood as limiting the scope of the disclosure. For those of ordinary skill in the art, several modifications and improvements may be made without departing from the inventive concept of the present disclosure, all of which fall in the protection scope of the embodiments of the present disclosure. Thus, the protection scope of the present disclosure should be subject to the contents of the claims.

## Claims

1. A flexible screen, **characterized by** comprising:
a flexible display panel, comprising a light-emitting surface;
equal thickness ultra-thin glass, connected to the light-emitting surface of the flexible display panel, wherein an edge of the equal thickness ultra-thin glass is disposed on an inner side of an edge of the flexible display panel; and
a screen protection layer, connected to a surface of the equal thickness ultra-thin glass away from the flexible display panel, wherein an edge of the screen protection layer is disposed on an outer side of the edge of the flexible display panel, an overhead area is defined between the screen protection layer and the flexible display panel, and the overhead area is disposed on an outer side of the edge of the equal thickness ultra-thin glass; and
a support stacking layer, disposed in the overhead area, wherein the support stacking layer is connected between the flexible display panel and the screen protection layer, the support stacking layer protrudes from the flexible display panel, and the support stacking layer is spaced apart from the equal thickness ultra-thin glass to define a gap.

2. The flexible screen according to claim 1, further comprising a filling member, wherein the filling member is disposed in the gap, and a material hardness of the filling member is less than that of the equal thickness ultra-thin glass.

3. The flexible screen according to claim 2, wherein the filling member is formed by curing an optical adhesive filled in the gap.

4. The flexible screen according to claim 1, further comprising an ink layer, wherein the ink layer is disposed between the screen protection layer and the support stacking layer, and the ink layer completely covers the gap.

5. The flexible screen according to claim 4, wherein an overlap width between the ink layer and the equal thickness ultra-thin glass is defined as k1, and 0.1mm ≤ k1 ≤ 0.5mm.

6. The flexible screen according to claim 5, wherein k1 is 0.1mm, 0.2mm, 0.3mm, 0.4mm, or 0.5mm.

7. The flexible screen according to claim 1, wherein a width of the gap is defined as k2, and 0.1mm ≤ k2 ≤ 0.5mm.

8. The flexible screen according to claim 7, wherein k2 is 0.1mm, 0.2mm, 0.3mm, 0.4mm, or 0.5mm.

9. The flexible screen according to claim 1 or 7, wherein an overlap width between the support stacking layer and the flexible display panel is defined as k3, and 0.2mm ≤ k3 ≤ 1mm.

10. The flexible screen according to claim 9, wherein k3 is 0.2mm, 0.3mm, 0.4mm, 0.5mm, 0.7mm, or 1mm.

11. The flexible screen according to claim 1, wherein the support stacking layer comprises a substrate layer and a pressure-sensitive adhesive layer, and the substrate layer is connected to the flexible display panel through the pressure-sensitive adhesive layer.

12. The flexible screen according to claim 11, wherein a material of the substrate layer comprises polyethylene terephthalate, transparent polyimide, or glass.

13. The flexible screen according to claim 11 or 12, wherein a thickness of the substrate layer is greater than that of the pressure-sensitive adhesive layer.

14. The flexible screen according to claim 1, further comprising a first optical adhesive layer, wherein the first optical adhesive layer covers the equal thickness ultra-thin glass and the support stacking layer, and the first optical adhesive layer connects the screen protection layer to the equal thickness ultra-thin glass and the support stacking layer.

15. The flexible screen according to claim 1, further comprising a second optical adhesive layer, wherein the equal thickness ultra-thin glass is connected to the flexible display panel through the second optical adhesive layer, and a thickness of the equal thickness ultra-thin glass is less than that of the second optical adhesive layer.

16. The flexible screen according to claim 15, wherein the support stacking layer comprises a substrate layer and a pressure-sensitive adhesive layer, the substrate layer is connected to the flexible display panel through the pressure-sensitive adhesive layer, and a thickness of the substrate layer is greater than that of the pressure-sensitive adhesive layer.

17. The flexible screen according to claim 1, further comprising a back film layer, a panel bottom protective layer, and a support member, wherein the back film layer, the panel bottom protective layer, and the support member are sequentially disposed on a back surface of the flexible display panel.

18. A foldable electronic device, **characterized by** comprising:
the flexible screen according to any one of claims 1 to 17.

19. The foldable electronic device according to claim 18, further comprising a middle frame and a hinge mechanism, wherein the middle frame comprises a first frame body and a second frame body, and the hinge mechanism is connected between the first frame body and the second frame body; the flexible screen is connected to the first frame body and the second frame body, and the flexible screen covers the hinge mechanism; and each of the first frame body and the second frame body comprises a flat part and a step part protruding from the flat part, a surface of the flexible display panel of the flexible screen away from the light-emitting surface is connected to the flat part, and a part of the support stacking layer protruding from the flexible display panel is connected to the step part.

20. The foldable electronic device according to claim 19, wherein an outer edge of the support stacking layer is spaced apart from a side wall of the step part.
